# EUROPEAN PATENT APPLICATION

(11) **EP 4 099 344 A1**
(43) Date of publication of application: **07.12.2022**
(21) Application number: 22175474.0
(22) Date of filing: 25.05.2022
(51) Int. Cl.: H01B 13/012, G01R 31/69

(54) **TEST APPARATUS FOR WIRING HARNESS BODY CLIPS**

(30) Priority: 01.06.2021 GB 202107772; 30.03.2022 GB 202204606
(71) Applicant: Aptiv Technologies Limited, St. Michael, 14004 (BB)
(72) Inventor: CARROLO, Nuno, 1500-911 Lisboa (PT); COSTA, Gabriel, 1675-020 Pontinha (PT); BARATA, Antonio, 6000-214 Castelo Branco (PT); FIGUEIRA DE ALMEIDA, Ricardo, 2735-382 Agualva (PT)
(74) Representative: Jones, David Alan

(57) **Abstract**

A test apparatus detects the presence of a connector (1) such as a body clip within a holder (30) of a wiring harness assembly board and is configured to confirm at least one characteristic of the connector (1) defined by a positional relationship between two features (2, 4) of the connector. The holder (30) has a receiving section for receiving the connector (1), and first and second contact elements (46, 56) that are engaged by the first and second features (2, 4) of the connector (1) when it is inserted in the holder (30). The first and second contact elements (46, 56) are operative to activate a signal generator (70). The first and second contact elements (46, 56) have a positional relationship corresponding to the desired characteristic of the connector (1) and are configured such that the signal generator (70) is only operated when the first and second contact elements (46, 56) are contacted simultaneously by the first and second features (2, 4) of the connector (1).

## Description

### FIELD OF INVENTION

The present disclosure relates to a test apparatus for detecting the presence of a body clip within a holder of a wiring harness assembly board and for confirming at least one desired characteristic of the connector.

### BACKGROUND

A wiring harness or wiring loom is a bundle of electrical cables used in automotive applications to transmit electrical power supply or data signals around a vehicle. Wiring harnesses are pre-assembled with the cables arranged in the correct routing lengths and configurations and bound together for example using tape, clips, cable ties, or conduits. The terminal ends of the cables are provided with connector elements for electrical connection to the associated in-vehicle components. The wiring harness is also provided with connectors at various locations along its limbs for mechanically connecting the cable harness to various structures within the vehicle. These connectors are commonly referred to as body clips.

A wiring harness comprises an extensive network of cables that extend around the entire vehicle. Each location within a vehicle presents a different mounting requirement due to its surface shape, orientation and the surrounding environment. The size and shape of the wiring harness itself also varies along its various limbs. Therefore, a variety of different clips are required depending on the mounting location within the vehicle and the specific location along the wiring to which the clip is secured.

Many body clips typically comprise a t-shaped moulded plastic body having an elongate body section and a head section formed in a flange arrangement. In use the body section is inserted into a corresponding pre-formed aperture in the vehicle body and may include retaining elements such as barbs for retaining the clip within the aperture. The head section limits insertion of the body section and provides a mounting structure for the cables.

It is important when assembling a wiring harness that a body clip is provided at each required location along the harness. It is also essential that the correct body clip is provided at each location. This is complicated by the fact that many clips appear similar or have several common features. Failure to include a body clip at a given location, or the inclusion of an incorrect body clip prevents or hinders the installation process and requires the installation to be halted while a correct body clip is located, resulting in delay. This may also result in the harness being rejected and returned to the manufacturer.

Wiring harnesses are assembled on an assembly board or workbench, which typically comprises a schematic of the wiring routes and includes labelling indicating the required components at each associated location along the harness. The electrical components are retained in mountings on the assembly board for connection to the cables, and cable laying guides and supports are arranged on the assembly board for guiding and angling the cables.

It is known to provide body clip holders on a wiring harness assembly board that are configured to receive the body clips at each associated location and provide an electrical signal confirming the presence of the body clip at that location. During assembly, each body clip is connected to the wiring harness at its given location and at the same time inserted into the body clip holder. When assembly is complete, the body clip holders provide an indication of the body clips installed at each location and the absence of a signal enables the installers to identify a missing clip. However, commonly known body clip holders do not indicate whether the correct clips have been installed at each location. Therefore, an assembly with a confirmed full complement of body clips may include one or more present but incorrect body clips. As a result, a wiring harness that has passed a body clip test may be rejected during installation due to the presence of incorrect body clips or may at least hinder assembly.

It is therefore desirable to provide an improved test apparatus for a connector which addresses the above-described problems and/or which offers improvements generally.

### SUMMARY

According to the present disclosure there is provided a test apparatus for a connector as described in the accompanying claims.

In an aspect of the disclosure there is provided a test apparatus for detecting the presence of a connector such as a wiring harness body clip and for confirming a desired characteristic of said connector, the connector having first and second features with a positional relationship that defines the desired characteristic of the connector, the test apparatus comprising a holder for receiving a connector; a signal generator operable to generate a signal confirming receipt in the holder of a connector having the desired characteristic; and first and second contact elements operable to activate the signal generator, the first contact element is arranged to be engaged and operated by the first feature of the connector when the connector is inserted in the holder and the second contact element is arranged to be engaged and operated by the second feature of the connector when the connector is inserted in the holder. The signal generator is only activated when the first and second contact elements are simultaneously operated.

The term "contact element" includes any element arranged to cause operation of the signal generator, either directly or indirectly, when engaged by the connector and may include for example push rods, spring contacts, contact sensors or any other suitable contact operable means. The term first and second "features" refers to any distinct and physically spaced elements of the connector having a positional desired positional relationship. The term "signal generator" includes any means of generating a signal, which may for example be a digital signal, wireless signal, electrical current, or audio signal.

The signal generator may comprise a transmitter operative to transmit a wireless signal when the first and second switches are operated simultaneously, the wireless signal confirming the presence of a connector in the holder and confirming that the connector has said at least one desired characteristic. The transmitter may be any suitable wireless transmitter.

The test apparatus includes an error proof means of verifying that the connector inserted in the holder is the correct connector required at the location along the wiring harness at which the test apparatus is located. It does this by verifying that the connector has a desired physical characteristic specific to that connector. Each test apparatus is provided with a unique identifier and is configured to validate a specific connector. Certain features of the test apparatus will prevent insertion of an incorrect connector altogether. Other features ensure that small deviations from the required characteristics of the connector will be detected and prevent the test apparatus providing a positive signal.

The first and second contact elements may be arranged in a positional relationship corresponding to the desired characteristic such that they may only be engaged simultaneously by the respective first and second features of a connector having the desired characteristic. In this way the signal generator is only activated when a connector having the desired characteristic is inserted into the holder. The holder preferably comprises a receiving section for receiving a connector.

The connector may have a body section having a longitudinal axis and the first and second features of the connector are axially offset. The axial offset defines at least one desired characteristic of the connector. The first and second contact surfaces are offset by a distance corresponding to the desired axial offset of the connector, such that they can only be simultaneously engaged by the first and second features of a connector having the desired axial offset.

The test apparatus may comprise at least one switch operable to activate the signal generator and the at least one switch is operated when the first and second contact elements are engaged simultaneously by the respective first and second features of the connector.

The holder may comprise first and second contact surfaces having a positional relationship corresponding to the desired characteristic of the connector and wherein the first and second contact elements are arranged at the first and second contact surfaces respectively such that they are operated by the respective first and second features of the connector when the first and second features engage the respective first and second contact surfaces.

The first and second contact elements may be movable between a raised position in which they project above the first and second contact surfaces respectively and a lowered position, and wherein the first and second contact elements are moved to the lowered position when engaged by the respective first and second features of the connector and wherein the signal generator is activated when the first and second contact elements are simultaneously moved to the lowered position. In the lowered position the distal ends are substantially flush with the contact surfaces.

A test apparatus may comprise first and second switches. The first contact element is operable to activate the first switch when engaged by the first feature of the connector and the second contact element is operable to activate the second switch when engaged by the second feature of the connector, and wherein the signal generator is activated when the first and second switches are activated simultaneously.

At least one of the first and second switches may be a contact switch comprising a contact surface.

The first and second switches may be operated simultaneously by the first and second contact elements when the first and second contact surfaces are engaged by the first and second features of the connector respectively.

The test apparatus may further comprise an electric generator, which in one embodiment may be a piezo electric generator for supplying electrical power to the signal generator. The first switch operates the piezo electric generator when the first contact element is engaged by the first feature of the connector to generate electric power to be supplied to the signal generator. The piezo electric generator advantageously ensures that the holders do not require connection to an external power supply. The first switch may be a push switch having a plunger element configured to engage a switch or lever of the piezo electric generator when actuated by the body clip. It will be appreciated that in other embodiments any suitable alternative electrical generation means may be utilised.

The second switch may reconfigurable between an open state and a closed. In the open state the second switch opens an electrical circuit. The second switch is reconfigured to the closed state when the second contact element is engaged by the second feature of the connector, which closes the electrical circuit. The signal generator forms part of the electrical circuit and may only be activated when the second switch is in the closed state to complete the circuit.

The signal generator, piezo electric generator and first and second switches may be operatively connected such that the piezo electric generator is operated to generate power and the electrical circuit is closed to enable power from the piezo electric generator to be supplied to the transmitter only when the first and second switches are simultaneously operated.

The first and second contact elements may be movable between a raised configuration and a depressed configuration, and each includes biasing means arranged to return the contact element to the raised configuration.

A test apparatus may be configured for detecting the presence of a connector comprising a body section and a head section, the body section having a distal end and the head section having a base surface and the axial offset between the base surface and the distal end defining the desired characteristic.

The holder may include a receiving section comprising an axially extending channel having an opening and a base defining the first contact surface, and a support surface surrounding the opening of the channel defining the second contact surface. The base of the channel and the support surface are axially offset by a distance corresponding to the axial offset defining the desired characteristic of the connector.

The head section of the connector may have a peripheral shape defining a second desired characteristic of the connector. The axially extending channel is configured to receive the body section of the connector, and the support surface surrounding the channel is surrounded by a peripheral wall defining a further recess or channel for receiving the head section. The recess has a peripheral shape defined by the peripheral wall corresponding to all or part of the shape of the head i.e. the second desired characteristic, such that only a head having the same peripheral shape is able to be received in the recess. The recess having a peripheral shape corresponding to at least part of the desired peripheral head shape of the connector permits insertion of connectors having said desired peripheral head shape and provides a mechanical obstruction that prevents insertion of connectors not having said desired peripheral head shape. The test apparatus thereby provides a two- stage verification of the connector, confirming both the head shape and length of the body section from the lower edge of the head.

The signal generator may be a wireless transmitter configured to transmit a unique identifier corresponding to the holder. The unique identifier is any data that relates to and identifies the holder. This enables the system to associate the signal with the holder and confirm based on the body present signal that the holder is in receipt of the correct body clip.

The test apparatus may further comprise a receiver for receiving a signal from the signal generator and a processor operative to identify the holder and confirm the presence in said holder of a connector having said at least one desired characteristic based on said signal. The processor may include pre-programmed information relating to the holders, the corresponding identifier for each holder and/or the type of connector associated with each holder.

The test apparatus may include a switch operative to activate or permit activation of the signal generator, and a movable contact member arranged to move between an open position and a closed position in which it operates the switch. The contact member is operatively connected to the first and second contact elements, meaning it may be moved directly or indirectly be the contact elements, and such that it is moved to the closed position when the first and second contact elements are simultaneously engaged by the first and second features of the connector respectively.

The first and second contact elements may comprise first and second push rods respectively that are arranged to be engaged by the first and second features and to operate the contact member to activate the switch only when simultaneously engaged by the first and second features.

The test apparatus may include a rocker element pivotally mounted within the housing about a pivot axis, the first and second push rods each having distal ends arranged to be engaged by the first and second features of the connector and proximal ends that engage and operate the rocker element on opposing sides of the pivot axis, wherein the rocker element is operatively connected to the contact member such that when the rocker element is operated simultaneously by the first and second push rods it causes movement of the contact element to the closed position and when the rocker element is operated by only one of the first and second push rods it rotates about the pivot axis without causing movement of the contact element.

The first and second push rods may be axially depressed when engaged by the respective first and second features, and wherein the contact member comprises a third push rod that is axially depressed to the closed position by eth first and second push rods, the contact member having a first end to which the rocker element is pivotally mounted and a second end that engages the switch when the contact member is depressed. The proximal ends of the push rods are pivotally connected to the rocker element.

The distal ends of the push rods may be axially offset by a distance corresponding to the desired characteristic of the connector.

The first and second push rods may be connected to the rocker element at equally spaced locations along the rocker element either side of the pivot axis.

The first push rod may extend through an aperture in the second contact surface. In the open position the contact element is spaced from the switch by an engagement distance and the distal end of the first push rod extends above the second contact surface by a distance equal to the engagement distance and the support surface limits axial travel of the first push rod to the engagement distance.

A peripheral shape of the head section of the connector may define another desired characteristic, with the holder being configured to receive a connector having a specific predetermined head shape. The housing includes a recess for receiving the head section of the connector when the body section is received within the receiver of the holder. The recess has a peripheral shape corresponding to the desired peripheral shape of the head section of the connector such that it permits insertion of connectors having said desired peripheral head shape and prevent insertion of connectors not having said desired peripheral head shape.

In another aspect of the invention a wiring harness test system may comprise a wiring harness assembly board having a support surface including a predefined wiring route along which the wiring harness is mounted. The assembly board includes a plurality of holders as described above arranged at locations along the wiring route corresponding to connector locations. Each holder has a unique identifier and is configured to confirm the presence of a connector in the holder and to confirm that the connector has at least one desired characteristic specific to the connector required at that location. A processor is operative to receive a signal from each holder and to confirm based on said signals whether each holder contains a connector and whether said connector has the desired characteristic corresponding to that location.

The signal from each holder may be transmitted wirelessly to the processor and the processor is operative to provide an indication if a connector is absent from one or more of the holders or if one or more of the holders contains an incorrect connector.

The contact elements may each include a contact surface and contact surfaces of the first and second switches project above the first and second contact surfaces respectively and are movable when engaged by the corresponding first and second features of the connector to an operative position in which they are flush with the first and second contact surfaces respectively to operate the first and second switches.

The second switch may be arranged to prevent operation of the transmitter when in an open state and to permit operation of the transmitter when engaged by the respective second feature. The holder includes an electric circuit connecting the transmitter to a power supply and the second switch is arranged to open the electrical circuit in a first open state and close the circuit to allow operation of the transmitter in a closed state.

The first and second contact elements may each includes biasing means arranged to return the contact element to a raised configuration. The first and second switches may be microswitches such as spring contact push switches.

The receiver may comprise an axially extending channel having a base for receiving the body section of a body clip, and a support surface surrounding the channel, and one of the first and second switches is located at the base of the channel and the other is located at the support surface, and wherein base of the channel and the support surface are axially offset by a distance corresponding to the desired axial offset of the connector.

The second switch may be reconfigured from an open state to a closed state when the second contact element is engaged by the second feature of the connector and is arranged to prevent operation of the signal generator/transmitter when in open state and to permit operation of the transmitter when in the closed state.

A receiver may be provided for receiving the wireless signal and a processor operative to identify the holder based on the wireless signal and confirm the presence in said holder of a body clip having said at least one desired characteristic.

In another aspect of the disclosure a wiring harness assembly system comprises a support surface including a predefined wiring route along which the wiring harness is mounted, the support surface including a plurality of test apparatus according to any preceding claim arranged at locations along the wiring route corresponding to body clip connector locations, each test apparatus having a unique identifier and being configured to confirm the presence of a body clip connector in the test apparatus and that the connector has at least one desired characteristic specific to the connector required at that location, and a processor operative to receive a signal from each test apparatus and to confirm based on said signal that each holder contains the correct connector.

The signal from each test apparatus may be transmitted wirelessly to the processor. The processor may be operative to provide an indication that a connector is absent from one or more of the test apparatus or that one or more of the test apparatus contains the incorrect connector and/or that a full complement of correct connectors is present.

The processor may be operative to provide an indication that a connector is absent from one or more of the test apparatus or that one or more of the test apparatus contains the incorrect connector.

In another aspect of the disclosure there is provided a test apparatus for detecting the presence of a connector such as a wiring harness body clip within a holder of a wiring harness assembly board, and for confirming at least one desired characteristic of said connector, said connector having first and second features with a positional relationship that defines said at least one desired characteristic of the connector; the test apparatus comprising a holder having a receiving section for receiving a connector; a first contact surface arranged to be engaged by the first feature of the connector when the connector is inserted in the receiving section; and a second contact surface arranged to be engaged by a second feature of the connector when the connector is inserted in the receiving section; a first contact element operable to activate a first switch and arranged relative to the first contact surface such that the first contact element is engaged by the connector to operate the first switch when the first feature of the connector engages the first contact surface; a second contact element operable to activate a second switch and arranged relative to the second contact surface such that the second contact element is engaged by the connector to operate the second switch when the second feature of the connector engages the second contact surface. The first and second contact surfaces have a positional relationship corresponding to the desired characteristic of the connector such that the first and second switches are operated simultaneously when the first and second contact surfaces are engaged by the first and second features of the connector respectively.

In another aspect of the disclosure there is provided a test apparatus for detecting the presence of a mechanical connector such as a wiring harness body clip and for confirming at least one desired characteristic of said connector, said connector having first and second features with a positional relationship that defines said at least one desired characteristic of the connector. The test apparatus comprises a housing having a receiver for receiving and retaining a connector and a switch. A contact element is arranged to move between an open position in which it is spaced from the switch and a closed position in which it operates the switch. A first mechanical engagement element is arranged to be engaged by a first feature of the connector when the connector is inserted in the receiver. A second mechanical engagement element is arranged to be engaged by a second feature of the connector when the connector is inserted in the receiver. The contact element is arranged to move to the closed position when the connector is inserted in the receiver and the first and second mechanical engagement elements are arranged to prevent movement of the contact element to the closed position unless the first and second mechanical engagement elements are simultaneously contacted by the first and second features of the connector respectively. The contact element is any element that is movable to operate the switch. The contact element may be an independent component or may be part of another component, for example an inner end of one of the first or second mechanical engagement elements. The switch may be configured to generate a signal when operated and may be any switch suitable to be operated by movement of the contact element. The test apparatus thereby provides a receiver or holder for receiving a connector, which in use is located on a wiring harness test board at the location of a given body clip. The test apparatus includes an error proof mechanical means of verifying that the connector inserted in the holder is the correct connector required at the location along the wiring harness at which the test apparatus is located.

### BRIEF DESCRIPTION OF THE DRAWINGS

The present disclosure will now be described by way of example only with reference to the following illustrative figures in which:
**Figure 1** is a conventional body clip for a wiring harness;
**Figure 2** is a plan view of the body clip of Figure 1;
**Figure 3** is a test apparatus according to an embodiment of the present disclosu re;
**Figure 4** is a plan view of the test apparatus of Figure 3;
**Figure 5** is an illustrative representation of a test apparatus according to an embodiment of the present disclosure;
**Figure 6** is an illustrative representation of a test apparatus according to an embodiment of the present disclosures containing a correct body clip;
**Figure 7** is an illustrative representation of a test apparatus according to an embodiment of the present disclosure containing a body clip having a head section that is too large;
**Figure 8** is an illustrative representation of a test apparatus according to an embodiment of the present disclosure containing a body clip having a body section that is too long;
**Figure 9** is an illustrative representation of a test apparatus according to an embodiment of the present disclosure containing a body clip having a body section that is too short;
**Figure 10** is a test apparatus according to an embodiment of the present disclosu re;
**Figure 11** is a plan view of the test apparatus of Figure 3;
**Figure 12** is an illustrative representation of a test apparatus according to an embodiment of the present disclosures in the neutral condition;
**Figure 13** is an illustrative representation of a test apparatus according to an embodiment of the present disclosures in a first imbalanced condition;
**Figure 14** is an illustrative representation of a test apparatus according to an embodiment of the present disclosures in a second imbalanced condition;
**Figure 15** is an illustrative representation of a test apparatus according to an embodiment of the present disclosures in an actuated condition;
**Figure 16** is an illustrative representation of a test apparatus according to another embodiment of the present disclosures in the neutral condition; and
**Figure 17** is an illustrative representation of the test apparatus of Figure 9 in an actuated condition.

### DESCRIPTION OF EMBODIMENTS

The following description presents exemplary embodiments and, together with the drawings, serves to explain principles of the present disclosure. The scope of the present disclosure is not intended to be limited to the precise details of the embodiments or exact adherence with all method steps. Variations will be apparent to a skilled person and are deemed also to be covered by the description. Terms for features used herein should be given a broad interpretation that also encompasses equivalent functions and features. In some cases, several alternative terms (synonyms) for structural features have been provided but such terms are not intended to be exhaustive.

Descriptive terms should also be given the broadest possible interpretation; e.g. the term "comprising" as used in this specification means "consisting at least in part of" such that interpreting each statement in this specification that includes the term "comprising", features other than that or those prefaced by the term may also be present. Related terms such as "comprise" and "comprises" are to be interpreted in the same manner. Directional terms such as "vertical", "horizontal", "up", "down", "upper" and "lower" are relative terms that may be used for convenience of explanation usually with reference to the illustrations and are not intended to be ultimately limiting if an equivalent function can be achieved with an alternative dimension and/or direction.

The description herein refers to embodiments with particular combinations of configuration steps or features. However, it is envisaged that further combinations and cross-combinations of compatible steps or features between embodiments will be possible. The description of multiple features in relation to any specific embodiment is not an indication that such features are inextricably linked, and isolated features may function independently as an invention from other features and not necessarily require implementation as a complete combination.

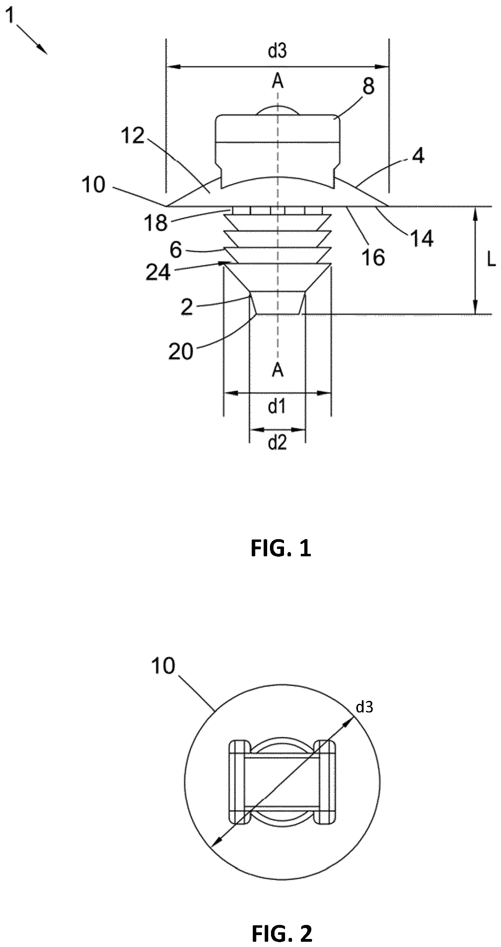

Referring to Figure 1, a commonly known cable body clip 1 for securing a wiring harness comprises a body 2 and a head 4. The body 2 is an elongate shaft and the head 4 is arranged perpendicular to the longitudinal axis of the body 2. The body clip 1 of Figure 1 is a 'fir tree' clip having a series of barbs 6 arranged along the body 2.

The barbs 6 are angled upwardly in the axial direction of the head 4 and are arranged to deflect radially inwardly when the body 2 is inserted into a pre-drilled hole in a vehicle body panel. The barbs 6 return to their pre-flexed position when inserted fully through the hole and engage the inner side of the body panel to prevent retraction of the body 2 from the hole. The head 4 includes a mounting feature 8 for securing to and supporting a section of a wiring harness. The mounting feature 8 is located on the upper surface 10 of the head 4 on the opposing side of the head 4 to the body 2, and in use faces outwardly away from the body panel of the vehicle. The mounting feature 8 may be configured to be strapped, taped or otherwise secured to the cable harness in any other suitable way.

The body 2 has a cross sectional shape in the plane perpendicular to its longitudinal axis A-A. The cross-sectional shape of the body 2 may vary from clip to clip. For example, the body 2 of certain body clips 1 may include longitudinally extending channels of varying radial depths. The number and position of the channels may vary from clip to clip. Other clips may have a non-circular cross-sectional form. The receiving channel may have a cross sectional shape corresponding to the cross-sectional shape of the body section to only permit insertion of a body section having the correct cross section. This feature may be provided independently or in combination with the other test features.

The head 4 has a peripheral edge 10. The head 4 includes an outer surface 12 and an inner surface 14 having a lower edge 16. The body 2 projects from the lower surface 14 of the head 4 in a direction away from the head 4. The body 2 has a longitudinal axis A-A that is arranged perpendicular to the lower edge 16 of the head 4. The body 2 has a proximal end 18 and a distal end 20.

The body 2 has an outer diameter *d1* defined by the unflexed diameter of the barbs 6, and an inner diameter *d2* defined by the diameter of the shaft of the body section 2 from which the barbs 6 extend. The body 2 also has a length *L* defined by the distance from the lower edge 16 of the head 4 to the distal end 20.

The head 4 has a diameter *d3.* As shown in Figure 2, the peripheral edge 10 of the head 4 has a circular shape. The shape of the peripheral edge 10, the diameter *d3* of the head 4, and the length L of the body 2, vary between body clips. Each body clip 1 has a specific combination of the shape of its peripheral edge 10, the diameter *d3* of the head 4, and the length L of the body 2. For each body clip, the diameter *d3* of the head 4 is greater than the inner diameter *d2* of the body 2 and typically greater than the outer diameter d1 of the body 2. It will be appreciated that for non-circular heads, the diameter of the head 4 will not be constant. The diameter d3 therefore represents a maximum distance across the head 4.

As the diameter *d3* of the head 4 is greater than the inner and outer diameters *d1,d2* of the body 2 the head 4 projects outwardly of the body in a direction perpendicular to the longitudinal axis A-A of the body 2. The pre-drilled holes of the vehicle body are formed to be substantially equal to the inner diameter *d2* of the body 2 and less than the outer diameter *d1* of the body 2. As such, as the body 2 is inserted through the holes the barbs 6 are caused to flex inwardly and remain flexed until they have passed fully through the pre-drilled hole at which point they return to their unflexed state with the outer surface 24 of the barbs 6, that is to say the surface of the barbs which face in the direction of the head 4, engaging the inner surface of the body panel to prevent retraction. The lower edge 16 of the diametrically larger head *d3* defines a flange that engages the region of the body panel immediately surrounding the pre-drilled hole to stop the body clip 1 and prevent further insertion. Other known examples of body clips include different head configurations or may be provided without a head as described above. Such 'headless' body clips include alternative features which extend radially outwards of the body section and limit insertion of the body section. The term 'head' is therefore used broadly herein to encompass any radially expanded engagement feature of the connector that limits insertion of the body section into the aperture of the body panel. The body length L may be the distance from the lower edge of any such engagement features to the lower end of the body section.

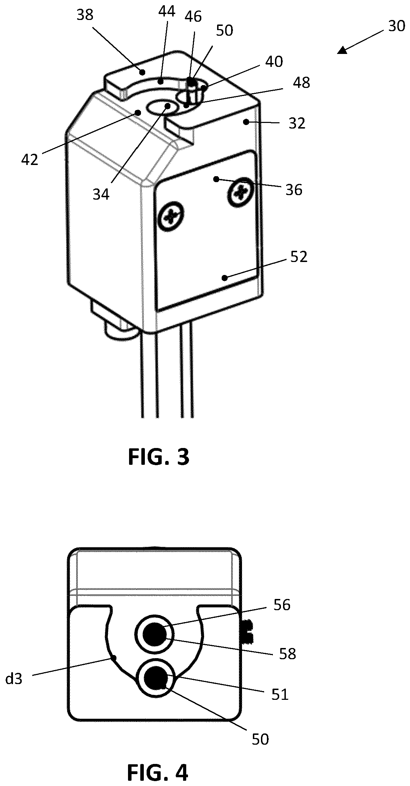

The combination of the length L of the body 2, the diameter d3 of the head 4 and the peripheral shape 22 of the head 4 is unique to each clip. Therefore, the ability to confirm at least one of these characteristics, together with positive confirmation of the presence of a body clip at a required location along a wiring harness, enables a determination that the correct body clip has been selected. Accordingly, the present disclosure provides a test apparatus 30 as shown in Figure 3, that is a body clip holder configured to retain a body clip, such as but not limited to the body clip 1 described above and confirm the presence of the retained body clip 1. The body clip holder 30 is also configured to confirm that the retained body clip 1 comprises the body length L and peripheral head shape 22 conforming to the body clip 1 required at the given location of the body clip holder 30 along the wiring harness, as will be described in further detail.

Referring to Figure 3, the body clip holder 30 is a body clip holder that comprises a body 32 which in use is connected to a wiring harness assembly board at the location on a test board of a given body clip 1. The body 32 includes a channel 34 extending into the body that is configured to receive the section 2 of the body clip 1. The channel 34 has a diameter substantially equal to the inner diameter d2 of the body section 2 and less than the outer diameter d1 to provide a positive engagement between the body section 2 and the side walls of the channel 34 to hold and retain the body section 2 within the channel 34. The body 32 of the body clip holder 30 defines a housing having side walls 36 and an upper surface 38. A recess 40 is formed in the upper surface 38. The recess 40 extends axially downwardly into the body 32. The recess 40 has a base surface 42 and side walls 44 defining a peripheral edge to the recess 40. The shape of the peripheral edge 44 is shaped to correspond to the peripheral edge 10 of the head 4 of the body clip 1. The recess 40 is arranged relative to the channel 34 to receive the head 4 when the body section 2 of the body clip 1 is inserted in the channel 34.

Each body clip holder 30 is located at a unique location along the wiring harness route. The shape of the peripheral edge 44 of the recess 40 of each body clip holder 30is shaped to correspond to the shape of the peripheral edge 10 of the body clip 1 intended for use at the specific location at which the body clip holder 30 is located. The shape of the peripheral edge 44 therefore provides a first check that the correct body clip has been selected. That is to say that a body clip 1 with a peripheral edge 10 shaped differently to the peripheral edge 44 of the recess 40 will not be capable of being inserted into the recess 40.

When a body clip 1 is inserted in the body clip holder 30 the body section 2 is firstly received within the channel 34 and, assuming the shape of the peripheral edge 10 conforms to the shape of the peripheral edge 44 of the recess 40, the head 4 is received within the recess 40. The body section 2 extends within the channel 34 until the lower edge 16 of the head 4 comes into engagement with the base of surface 42 of the recess 40, which defines an abutment surface preventing further axial insertion of the body clip 1.

The body clip holder 30 includes a first microswitch 46 received within an axially extending channel 48 arranged parallel to the channel 34. The microswitch 46 is a cylindrical spring contact push switch. The microswitch 46 comprises a tubular barrel 47, a plunger 49 located within the tubular barrel, and a compression spring for returning the plunger to a raised position. A contact head 50 is arranged at the upper end of the plunger 49 and includes an upper contact surface 51. The barrel 47 is received within the channel 48 such that it is substantially embedded within the body 32 of the test apparatus. At least part of contact head 50 extends above the base of surface 42 of the recess 40. The channel 48 is arranged such that it extends through the base section 42 with the contact head 50 of the microswitch 46 extending upwardly through surface 42. The contact head 50 is arranged to be engaged by the lower surface 16 of the head 4 of the body pin 1 when the head 4 is inserted into the recess 40.

The body clip holder 30 includes a base section 52 located at the lower end of the housing 32 at the opposing end to the recess 40. Base section 52 contains a signal generator, which may be a wireless transmitter, as described in further detail below. The side wall 36 of the housing 32 includes a longitudinally extending channel arranged to partially intersect the recess 40. As shown in Figure 4, the channel 54 has a curved profile forming a scalloped cutaway into the recess 40. The channel 54 enables a user to engage the lower surface 10 of the head 4 of the body clip 1 to grip the body clip 1 and remove it from the test apparatus 30.

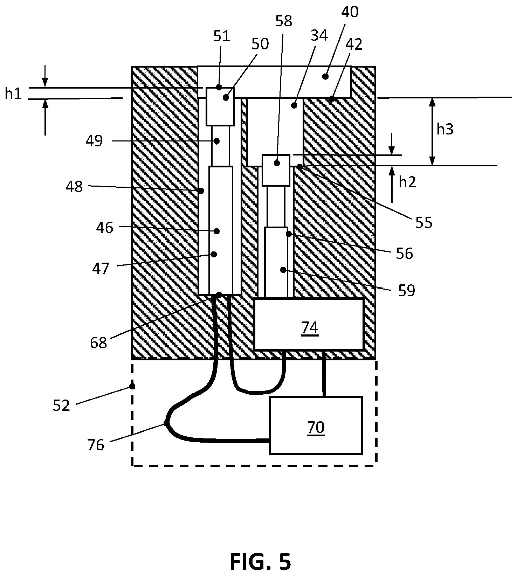

A diagrammatic representation of the internal structure of the body clip holder 30 is shown in Figure 5, which is a cross-sectional view through the housing 32. The channel 34 includes a base 55. A second microswitch 56 provided within a channel 57 located beneath the channel 34. The second microswitch 56 is also a spring contact push switch as described above. The barrel 59 of the second microswitch 56 is housed within the channel 57. The second microswitch 56 includes a contact head 58 having an upper contact surface 60. The second microswitch is arranged such that at least a portion of the contact head 58 extends above the base 55 of the channel 34. In a neutral condition the plungers of the first and second microswitches 46,56 are fully extended. The contact surface 52 of the first microswitch 46 projects a distance h1 above the base surface 42 of the upper recess 40. The upper contact surface 60 of the second microswitch 56 projects a distance h2 above the base surface 55 of the lower recess 34.

Depressing the contact head 50 by the distance h1 moves the upper contact surface 51 to a position where it is flush with the base surface 42 of the upper recess 40. In this position, the microswitch 46 is moved to a closed state. The distance h1 is equivalent to the distance of travel of the plunger 49 of the first microswitch 46 required for the electrical contacts of the first microswitch 46 to close. Similarly, depressing the contact head 58 by the distance h2 moves the upper contact surface 60 to a position where it is flush with the base surface 55 of the lower recess 40. Depressing the contact head 50 by the distance h1 moves the microswitch to a closed state as the distance h2 is equivalent to the distance of travel of the plunger 53 of the second microswitch 56 required for the electrical contacts of the second microswitch 56 to close.

The body clip holder 30 includes a piezo electric generator 74 housed in the base 52. The piezo electric generator includes a plunger or lever configured to activate the piezo electric generator when depressed causing it to generate an electrical voltage. The piezo electric generator is arranged such that it is activated by the second microswitch 56. When the plunger of the second microswitch 56 is depressed by a distance h2 it moves the plunger or lever of the piezo electric generator to the closed position to generate a voltage. In this embodiment, reference to the second microswitch 56 moving to a closed state refers to the microswitch being moved in a manner that causes it to operate the piezo electric generator. The second microswitch may be an integral part of the piezo electric generator and may comprise the plunger or lever piezo electric generator or may be a separate component that engages with the piezo electric generator, such as by engaging the plunger, lever or other actuation means of the piezo electric generator to generate a voltage.

The body clip holder 30 further includes a wireless transmitter 70 comprising an antenna 72 that is operational to transmit a signal when activated by a voltage from the piezo electric generator 74. The wireless signal transmitted by the wireless transmitter 70 includes data identifying the body clip holder 30 and providing a confirmatory indication that a body clip 1 is present within the body clip holder 30 and that the body clip 1 includes specific dimensional features confirming the correct body clip type has been inserted. The electrical voltage to power the antenna 72 is generated by the piezo electric generator 74 when actuated by the second microswitch 56. The voltage is transmitted from a pcb of the piezo electric generator 74 to a pcb of the antenna via an electrical circuit 76. The first microswitch 46 is connected to the electrical circuit in such a manner that the voltage can only be supplied to the antenna when the first microswitch 46 is in the closed state. That is to say the first microswitch 46 breaks the circuit 76 when in an open state. Therefore, for a voltage to be generated and transmitted to the antenna, to cause the antenna to transmit a wireless signal, both the first and seconds microswitches 46,56 must be in the closed configuration simultaneously. In other embodiments the second microswitch 56 may be connected to the electrical circuit and be arranged to close the circuit when depressed to cause the antenna to be operated by an alternative electrical power source.

The base surface 42 of the recess 40 surrounding the recess 34 forms a shelf that is arranged to support the lower surface 16 of the head 4 of the body clip 1 when the body clip 1 it is inserted into the body clip holder 30. The depth of the recess 34 is equal to the length L of the body 2 of the body clip 1. The vertical distance h3 between the base surface 42 of the recess 40 and the base surface 55 of the recess 34 is equal to the length L of the body 2. The shape of the recess 40 defined the shape of its peripheral edge correspond to the peripheral edge 10 of the head 4 of the body clip 1, such that the recess 40 is arranged a head of that specific shape and size. Therefore, a body clip 2 must have the required head size and shape, and the required body length to be received in the body clip holder 30 in such a way that the lower surface 16 of the head 4 engages the base surface 42 of the recess 40 and the lower end of the body 2 engages the base 55 of the recess 34. Consequently, only a body clip 2 having the required head size and shape and body length is able to depress the first and second microswitches 46,56 to the closed configuration simultaneously.

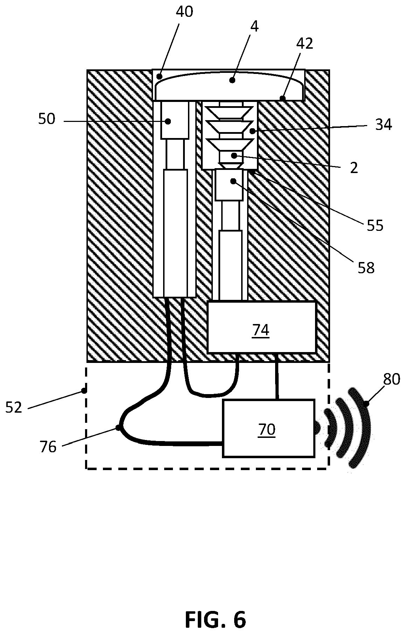

In the arrangement of Figure 6 the correct body clip 2 has been inserted into the body clip holder 30. The head 4, having the correct size and shape, is received within the recess 40 and the lower surface 16 contacts the base surface 42 of the recess 40 causing the head 50 of the first microswitch 46 to depress the distance h1. At the same, the body 2 has the correct length to contact the base 55 of the recess 34 as the lower surface 16 contacts the base surface 42. The body 2 cases the head 58 to depress the distance h2. As a result, the piezo electric generator 74 is activated y the second microswitch 56 and the circuit 76 is closed by the first microswitch 46. The voltage generated by the piezo electric switch 74 is therefore transmitted to the antenna 70 which transmits a wireless signal 80 confirming that the body clip 1 is present and is of the right type, and also transmits data identifying the body clip holder 1. The wireless signal is received by a receiver and the data is transferred to a processor which verifies the presence and correct selection of the body clip 2 and associates this with the identified body clip holder 30. If all body clips 1 are identified as being present and correct, the processor will provide a positive confirmation to the operator.

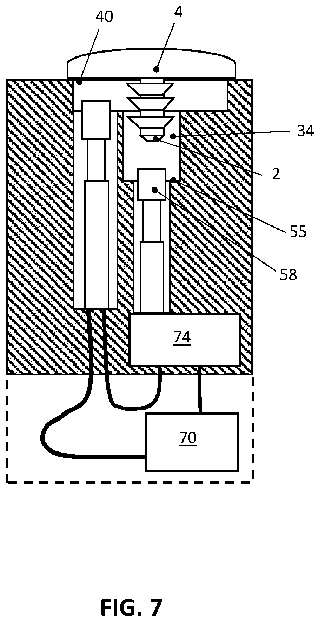

Figure 7 shows an arrangement in which the body clip head 4 is of the wrong size and/or shape. As a result, the head 4 cannot be received within the recess 40. In this situation neither the first nor second microswitches 46,56 are operated. The piezoelectric generator switch is therefore not operated and the circuit 76 remains open. Consequently, no wireless signal is transmitted. The processor identifies when an expected signal is not received from the body clip holder and a negative alert is generated indicating to the user that the body clip is incorrect or not present. The assembly procedure will not continue until positive confirmation is received.

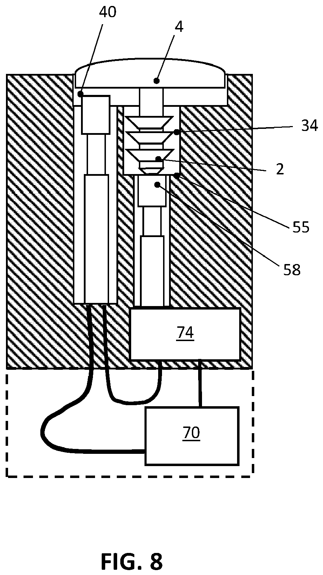

Figure 8 shows an arrangement in which the body 2 of the body clip 1 is too long. The distal end of the body 2 is in engagement with the base 55 of the recess 34 and the second microswitch 56 is depressed. However, the lower surface 16 of the head 4 is spaced from the lower surface 42 of the recess 40. The first microswitch 46 is therefore not depressed. The piezoelectric generator switch 74 is operated but the circuit 76 remains open. Consequently, the voltage is not transmitted to the antenna and no wireless signal is transmitted.

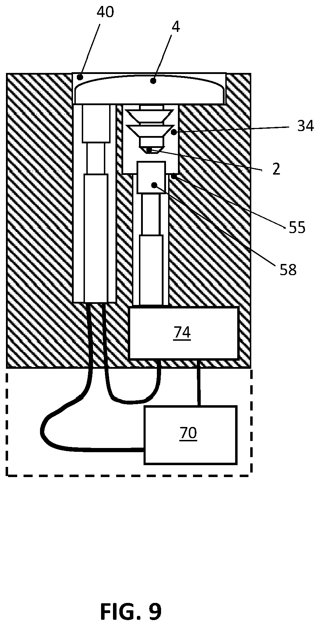

Figure 9 shows an arrangement in which the head 4 is the correct size and shape but the body 2 of the body clip 1 is too short. The lower surface 16 of the head 4 engages from the lower surface 42 of the recess 40 and depressed the microswitch 46. However, the distal end of the body 2 is spaced from the base 55 of the recess 34 and the second microswitch 56 is not depressed. The piezoelectric generator switch 74 is not operated, and therefore no voltage is transmitted to the antenna and no wireless signal is transmitted.

In further embodiments additional switches could be integrated into the body clip holder to confirm additional features of the body clip holder. For example, if two body clips have a head and body of the same size, other features of the head may be used to distinguish the two clips. Further switches located within the recess 40 for example could be engaged by protrusions of a first body clip and avoided by the second body clip in which such protrusions are absent. The disclosure therefore encompasses any number of microswitches or other electrical contacts or detectors that may be located at numerous locations on the holder to confirm any number of physical features or positional relationships of features on the body clip.

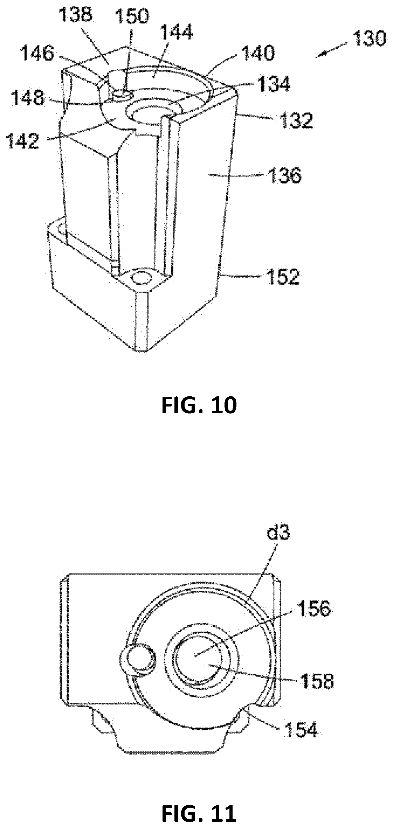

In another embodiment, as shown in Figure 10, the test apparatus 130 includes a first pin defining a first push rod 146. The first push rod 146 is received within an axially extending channel 148 arranged parallel to the channel 134. A head section 150 of the first push rod 146 extends axially above the base of surface 142 of the recess 140. The channel 148 is arranged such that it extends through the base section 142 with the head section 150 of the first push rod 146 extending through the base of surface 142. The head 150 of the first push rod 146 is arranged to be engaged by the lower surface 116 of the head 104 of the body pin 101 when the head 104 is inserted into the recess 140.

The test apparatus 130 includes a base section 152 located at the lower end of the housing 132 at the opposing end to the recess 140. Base section 152 contains a contact switch and a wireless transmitter as described in further detail below. The side wall 136 of the housing 132 includes a longitudinally extending channel arranged to partially intersect the recess 140. As shown in Figure 11, the channel 154 has a curved profile forming a scalloped cutaway into the recess 140. The channel 154 enables a user to engage the lower surface 110 of the head 104 of the body clip 101 to grip the body clip 101 and remove it from the test apparatus 130.

A second pin defining a second push rod 156 is located within the channel 134 and is slidingly received therein. The second push rod 156 includes a head 158 that in a neutral condition prior to insertion of the body clip 101 is axially spaced below the head 150 of the first push rod 146 and below the base surface of the recess 140. As can also be seen in Figure 4, the channel 148 of the first push rod 146 is located at the radial outer edge of the base surface 142 and partially intersects the peripheral edge 144 of the recess 140. This ensures that the head 150 of the first push rod 146 is engaged by the outer edge of the head 104 when the head 104 is inserted into the recess 140.

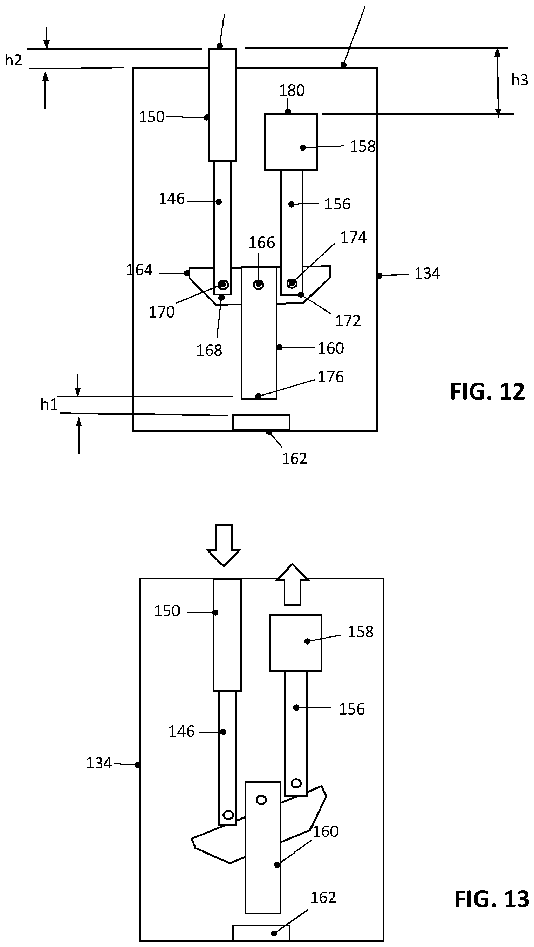

A diagrammatic representation of the internal structure of the test apparatus 130 is shown in Figure 12, which is a cross-sectional view through the housing 132. A third push rod 160 is provided within the housing 132. The third push rod 160 is slidingly received within a corresponding axially arranged channel formed within the housing or is otherwise supported within the housing 132 such that it is able to axially translate. A biasing means such as a compression spring may be provided to bias the third push rod 160 to a first raised position as shown in Figure 5. A contact switch 162 is located at the base of the housing 132 beneath the third push rod 160.

A rocker 164 is pivotally mounted to the upper end 166 of the third push rod 160. The third push rod 160 has a longitudinal axis that is arranged parallel to the longitudinal axis of the first push rod 146 and second push rod 156. The rocker 164 is mounted to the third push rod 160 by a pivot pin 166 and in the neutral position as shown in Figure 5 extends substantially perpendicular to the longitudinal axis of the third push rod 164 in a substantially T-shaped arrangement. The lower end 168 of the first push rod 146 is pivotally connected to the rocker 164 by a pivot pin 170. The pivot pin 170 is laterally spaced from the pivot pin 166 along the length of the rocker 164. The second push rod 156 is connected at its lower end 172 to the rocker 164 by a pivot pin 174. The pivot pin 174 is spaced from the pivot pin 166 along the length of the rocker 164 on the opposing side of the third push rod 160 from the pivot pin 170 of the first push rod 146.

The lower end surface 176 of the third push rod 160 is spaced from the contact switch 162 by an axial distance H1. The length of the first push rod 146 is selected such that the upper surface 178 of the head 150 of the first push rod 146 is axially spaced above the base surface 142 of the recess 140 by a corresponding distance H2 in the neutral position. The third push rod 160 is in the neutral position and the rocker 164 is un-tilted and arranged substantially perpendicular to the longitudinal axis of the third push rod 160. The distance H2 is selected to be equivalent to the distance H1. The distance between the upper surface 178 of the first push rod 146 and the upper surface 180 of the second push rod 156 is a distance H3 when the rocker 164 is in the neutral position substantially horizontal and perpendicular to the longitudinal axis of the third push rod 160. The distance H3 is selected to correspond to the required length L of the body section 102 of the body clip 101 associated with the test apparatus 134. In this way, when the body clip 101 is inserted into the channel 134 the lower surface 110 of the head 104 or other radially extended engagement feature will contact the upper surface 178 of the first push rod 146 at the same time that the distal end 120 of the body section 102 contacts the upper surface 180 of the second push rod 156 if the body clip 101 is correct.

Simultaneous contact of the head 104 with the first push rod 146 and the body 102 with the second push rod 156 enables the body clip 101 to push downwardly on the third push rod 160 via the push rods 146,156 without tilting the rocker. Applying a balanced force to the rocker 164 enables the third push rod 160 to be pushed downwardly against the biasing force of the compression spring to move the third push rod 160 into engagement with the contact switch 162. When the lower surface 110 of the head 104 has pushed the first push rod 146 downwardly a distance H2 the lower surface 110 comes into engagement with the lower base surface 142 of the recess 140 and is unable to push the first push rod 146 any further. As the distance H1 corresponds to the distance H2, the head 104 is therefore able to push the first push rod 146 a distance corresponding to the distance H1 required to make contact between the third push rod 160 and the contact switch 162. With the third push rod 160 in engagement with the contact switch 162 the body clip 101 is securely received within the channel 134 and the contact switch 162 provides an indication that the body clip 101 is present within the test apparatus 134. Furthermore, the fact that the contact switch 162 has been activated confirms that the body clip 101 has the correct length L and that the head 104 has the correct corresponding peripheral shape 122.

The arrangement of Figure 13 represents a situation in which an incorrect body clip 101 having a correctly shaped peripheral edge 110 but incorrect body length L has been inserted into the recess 140. The length L of the body section 102 is shorter than the desired length of the correct corresponding body clip 101. As such, the peripheral edge 110 of the head 104 engages the upper surface 178 of the first push rod 146 before the distal end 120 has engaged the upper surface 180 of the second push rod 156. The first push rod 146 therefore begins to move downwardly. Without the distal end 120 in engagement with the second push rod 156 the downward force on the rocker 164 is imbalanced causing the rocker to pivot downwardly about the pivot pin 166 on the head of the first push rod 146. At the same time, the opposing side of the rocker 164 pivots upwardly forcing the second push rod 156 to move upwardly. Therefore, because the length L of the body section 102 of the body clip 101 is too short, insertion of the body clip 101 into the test apparatus 134 only acts to pivot the rocker 164 and does not provide a downward force on the third push rod 160. As a result, the third push rod 160 remains spaced from the contact switch 162. The absence of contact between the push rod 160 and the contact switch 162 indicates that the incorrect body clip 101 has been inserted into the test apparatus 130 despite the shape of the peripheral edge 110 of the head 104 providing a visual indication that the correct clip has been selected.

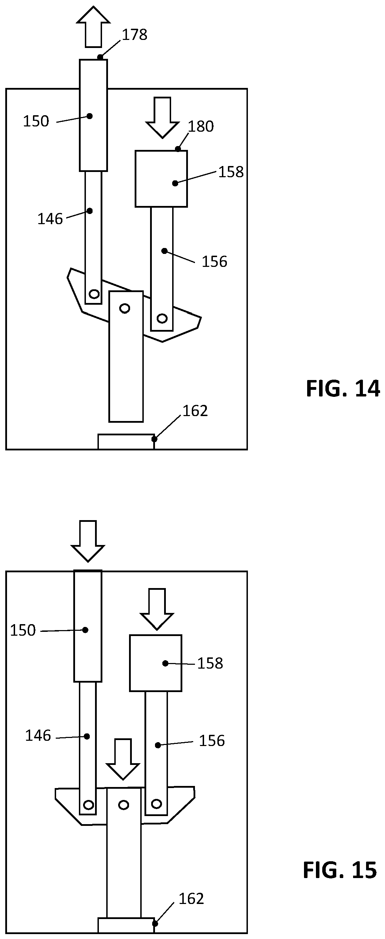

Figure 14 illustrates a situation in which an incorrect body clip 101 has been selected having a body section 102 with a length L that is greater than the specified length L of the correct body clip 101 corresponding to the test apparatus 130. As a result, when the body clip 101 is inserted into the test apparatus 134 the distal end 120 of the body section 102 contacts the upper surface 180 of the second push rod 156 before the lower edge 116 of the head 104 comes into engagement with the upper surface 178 of the first push rod 146. Consequently, the distal end 120 begins to push downwardly on the second push rod 156 and this force is not countered by the simultaneous engagement of the head 104 with the first push rod 146. As such, the second push rod 156 begins to push downwardly on the rocker 164 causing the rocker 164 to pivot about pivot pin 166 in a downward direction. At the same time, the opposing end of the rocker 164 pivots upwardly pushing the first push rod 146 in an upwards direction. The absence of simultaneous engagement of the head 104 and the body section 102 with the first push rod 146 and second push rod 156 respectively results in the downward force of the body clip 101 causing the rocker 164 to pivot rather than moving the third push rod 160 downwardly into contact with the contact switch 162. Again, the third push rod 160 remains spaced from the contact switch 162 providing an indication that the incorrect body clip 101 has been selected due to the absence of a signal from the contact switch 162.

In the arrangement of Figure 15 the correct body clip 101 has been selected having a head 104 with a peripheral edge 110 correctly shaped to correspond to the peripheral edge of the recess 140. The body section 102 has been inserted into the channel 134 until the distal end 120 contacts the upper surface 180 of the second push rod 156. The length L of the body section 102 corresponds to the height H3 between the upper surface 178 of the first push rod 146 and the upper surface 180 of the second push rod 156, and as such the lower surface 110 of the head 104 and the distal end 120 engage these corresponding surfaces simultaneously. The first push rod 146 and second push rod 156 apply balanced forces on opposing sides of the pivot pin 166 to the rocker 164 preventing the rocker 164 from pivoting. The downward force from the body clip 101 is transferred to the third push rod 160 via the pivot pin 166 causing the push rod 160 to move downwardly into engagement with the contact switch 162. As can be seen in Figure 8 the gap between the lower end of the third push rod 160 and the contact switch 162 has been closed and the third push rod 160 is in engagement with the contact switch 162. A signal is generated by the contact switch 162 to indicate the presence in the test apparatus 134 of the correct body clip 101. The signal from the contact switch 162 is transmitted to a processor by a wireless transmitter in the base 152 of the housing 132. Alternatively, the test apparatus 134 may be hard wired to the wiring harness assembly board.

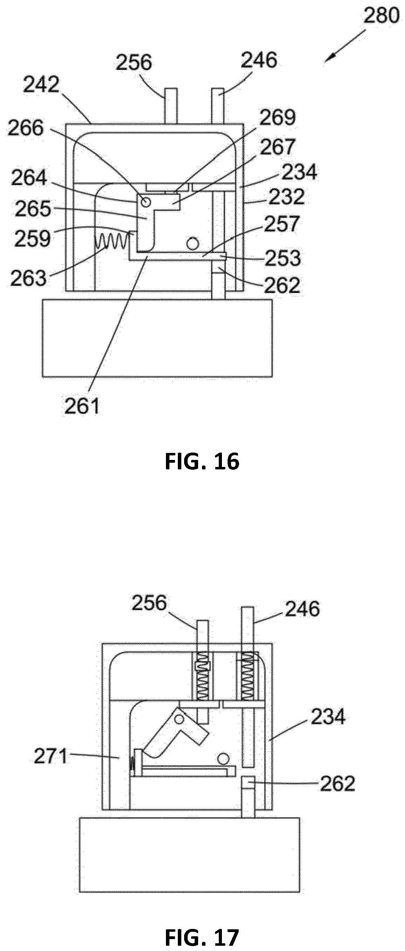

In another embodiment of the present disclosure as shown in Figure 16, a test apparatus 230 has a body 232 defining a housing 234 within which a first push rod 246 and second push rod 256 are slidingly received. The housing 234 includes an upper surface 242. In the neutral position, as shown in Figure 9, prior to insertion of the body clip 101 the upper ends of the first push rod 246 and second push rod 256 extend above the upper surface 242 of the housing 234. The first push rod 246 and second push rod 256 are arranged parallel to each other and slide axially within the housing 234. A contact switch 262 is located below the lower end of the first push rod 246 and is axially aligned with the first push rod 246 such that downward axial movement of the first push rod 246 brings it into engagement with the contact switch 262.

A stop plate 257 is located between the lower end of the first push rod 246 and the contact switch 262. The stop plate 257 is horizontally arranged in a direction perpendicular to the longitudinal axis of the first push rod 246. The distal end of the stop plate 257 locates in the gap 253 between the first push rod 246 and the contact switch 262. The proximal end of the stop plate 257 includes a shoulder 259 that is upwardly extending in a direction perpendicular to the main body 261 of the stop plate 257. A compression spring or other biasing member 263 urges the stop plate 257 to the default position in which it is located between the first push rod 246 and the contact switch 262.

An L-shaped rocker element 264 is located at the proximal end of the stop plate 257. A first limb 265 of the rocker element 264 is vertically arranged in the default position such that it is parallel with and in abutment with the stop shoulder 259 of the stop plate 257. A pivot pin 266 is located at the upper end of the first limb. A second limb 267 extends horizontally from the upper end of the first limb 265 in a plane perpendicular to the longitudinal axis of the second push rod 256. The upper surface 269 of the second limb of the rocker 264 is arranged beneath the lower end of the second push rod 256. The second limb 269 extends away from the first limb 265 in a direction away from the stop shoulder 259. The application of a downward force to the second limb 269 by the second push rod 256 causes the rocker 264 to pivot about the pivot pin 266 with the second limb 267 rotating downwardly while the first limb 265 rotates in an upwards direction. As the first limb 265 rotates it provides a lateral force against the stop shoulder 259 pushing the stop shoulder 259 against the action of the biasing member 263 causing the stop plate 257 to slide away from the neutral position in a direction away from the first push rod 246, exposing the gap 253 between the first push rod 246 and the contact switch 262 enabling the push rod 246 to move axially into engagement with the contact switch 262 when a downward force is applied to the first push rod 246.

As shown in Figure 17, a stop member 271 is located on the opposing side of the stop shoulder 259 to the rocker 264. The stop element 271 limits movement of the stop plate 257 when the stop plate 257 has moved out of the gap 253 between the first push rod 246 and the contact switch 262. When the stop plate 257 is stopped by the stop element 271 further rotation of the rocker 264 is prevented. A further housing element (not shown) is located above the housing section 234, which includes a recess for receiving the head 104 of the body clip 101 and a channel for receiving the body of the body clip 101. The channel and recess of the upper housing section are arranged such that the body 102 of the clip 101 slides into engagement with the second push rod 256 and such that the head 104 of the body clip 101 is able to engage the first push rod 246.

In use, when a body clip 101 is inserted into the upper housing the distal end 120 of the body clip 101 engages the second push rod 256 forcing the second push rod 256 downwardly into engagement with the upper surface 269 of the rocker 264. The rocker 264 is caused to rotate causing the stop plate 257 to begin to slide in a direction away from the first push rod 246. If the length L of the body section 102 is shorter than the length L of the body clip 101 for which the test apparatus 234 is specified, the head 104 will engage the first push rod 246 before the stop plate 257 has been fully removed from the gap 253,273 between the first push rod 246 and the contact switch 262. As such, the first push rod 246 is prevented from moving downwardly via the stop plate 257 and further downward movement of the body clip 101 is prevented. The body clip 101 is unable to further rotate the rocker 264 and the first push rod 246 is prevented from making contact with the contact switch 262. The contact switch 262 is therefore not engaged and no positive signal is created indicating that the incorrect body clip 101 has been inserted into the test apparatus 230. Conversely, if the body section 102 of the body clip 101 has a length L longer than the body clip 101 for which the test apparatus 230 has been specified, the downward movement of the second push rod 256 will cause the rocker 264 to rotate position to where the stop element 271 is engaged by the stop shoulder 259. At this point, the lower surface 116 of the head 104 of the body clip 101 has still not engaged the first push rod 246 or has not engaged the first push rod 246 to the extent that it has been pushed downwardly a sufficient distance to contact the contact switch 262. The distance of travel of the second push rod 256 is therefore selected such that only a body clip 101 having a body section 102 of the correct length L is able to engage the first push rod 246 once the stop plate 257 has been moved out of the gap 253 between the first push rod 246 and the contact switch 262 and still be able to move the first push rod 246 the correct distance into engagement with the contact switch 262 before the rocker 264 is pivoted to the extent that the stop shoulder 259 engages the stop element 271.

## Claims

1. A test apparatus for detecting the presence of a connector (1) such as a wiring harness body clip and for confirming a desired characteristic of said connector (1), the connector (1) having first and second features (2,4) with a positional relationship that defines the desired characteristic of the connector (1), the test apparatus comprising:
a holder (30) for receiving a connector (1);
a signal generator operable to generate a signal confirming receipt in the holder of a connector (1) having the desired characteristic; and
first and second contact elements (46,56) operable to activate the signal generator, the first contact element (46) is arranged to be engaged and operated by the first feature of the connector (1) when the connector (1) is inserted in the holder and the second contact element (56) is arranged to be engaged and operated by the second feature of the connector (1) when the connector (1) is inserted in the holder;
wherein the signal generator (70) is only activated when the first and second contact elements (46,56) are simultaneously operated.

2. A test apparatus according to claim 1, wherein the first and second contact elements (46,56) are arranged in a positional relationship corresponding to the desired characteristic such that they may only be engaged simultaneously by the respective first and second features (2,4) of the connector (1) having the desired characteristic.

3. A test apparatus according to claim 1 or 2, wherein the connector (1) has a body section having a longitudinal axis and the first and second features (2,4) of the connector (1) are axially offset by a distance defining the desired characteristic, the first and second contact elements (46,56) are axially offset by a distance corresponding to the desired characteristic of the connector (1).

4. A test apparatus according to any preceding claim, wherein the holder comprises first and second contact surfaces (55,42) having a positional relationship corresponding to the desired characteristic of the connector (1) and wherein the first and second contact elements (46,56) are arranged at the first and second contact surfaces (55,42) respectively such that they are operated by the respective first and second features (2,4) of the connector (1) when the first and second features (2,4) engage the respective first and second contact surfaces (55,42).

5. A test apparatus according to any preceding claim, wherein the first and second contact elements (46,56) are movable between a raised position in which they project above the first and second contact surfaces (55,42) respectively and a lowered position, and wherein the first and second contact elements (46,56) are moved to the lowered position when engaged by the respective first and second features (2,4) of the connector (1) and wherein the signal generator (70) is activated when the first and second contact elements (46,56) are simultaneously moved to the lowered position.

6. A test apparatus according to claim 5, comprising first and second switches and wherein the first contact element (46) is operable to activate the first switch when engaged by the first feature of the connector (1) and the second contact element (56) is operable to activate the second switch when engaged by the second feature of the connector (1), and wherein the signal generator (70) is activated when the first and second switches are activated simultaneously, and/or wherein

7. A test apparatus according to claim 6, wherein the first and second switches are operated simultaneously by the first and second contact elements (46,56) when the first and second contact surfaces (55,42) are engaged by the first and second features (2,4) of the connector (1) respectively.

8. A test apparatus according to claim 7, further comprising an electrical generator (74) for supplying electrical power to the signal generator (70), wherein the first switch operates the electrical generator (74) when the first contact element (46) is engaged by the first feature of the connector (1) and wherein the second switch is reconfigurable between an open state and a closed and is reconfigured to the closed state when the second contact element (56) is engaged by the second feature of the connector (1), and wherein the signal generator (70) may only be activated when the second switch is in the closed state.

9. A test apparatus according to claim 8, wherein the signal generator (70), electrical generator (74) and first and second switches are operatively connected such that the electrical generator (74) is operated to generate power and the power from the electrical generator (74) is supplied to the transmitter only when the first and second switches are simultaneously operated.

10. A test apparatus according to claim 9, wherein the holder includes a receiving section comprising an axially extending channel having an opening and a base defining a first contact surface, and a support surface surrounding the opening of the channel defining a second contact surface, and wherein the base of the channel and the support surface are axially offset by a distance corresponding to the axial offset defining the desired characteristic of the connector (1).

11. A test apparatus according to claim 10, being configured for detecting the presence of a connector (1) comprising a body section and a head section, the body section having a distal end and the head section having a base surface and the axial offset between the base surface and the distal end defines the desired characteristic.

12. A test apparatus according to claim 11, wherein the head section of the connector (1) has a peripheral shape defining a second desired characteristic of the connector (1), wherein the axially extending channel is configured to receive the body section of the connector (1), and the support surface surrounding the channel is surrounded by a peripheral wall defining a recess for receiving the head section and the recess has a peripheral shape corresponding to the second desired characteristic.

13. A test apparatus according to any preceding claim further comprising:
a switch operative to activate the signal generator (70);
a contact member arranged to move between an open position and a closed position in which it operates the switch;
wherein the contact member is operatively connected to the first and second contact elements (46,56) such that it is moved to the closed position when the first and second contact elements (46,56) are simultaneously engaged by the first and second features (2,4) of the connector (1) respectively.

14. A test apparatus according to claim 13, wherein the first and second contact elements (46,56) comprise first and second push rods (46,56) respectively that are arranged to be engaged by the first and second features (2,4) and to operate the contact member to activate the switch only when simultaneously engaged by the first and second features (2,4), and the test apparatus further comprises a rocker element pivotally mounted within the housing about a pivot axis, the first and second push rods each having distal ends arranged to be engaged by the first and second features (2,4) of the connector (1) and proximal ends that engage and operate the rocker element on opposing sides of the pivot axis, wherein the rocker element is operatively connected to the contact member such that when the rocker element is operated simultaneously by the first and second push rods (46,56) it causes movement of the contact element to the closed position and when the rocker element is operated by only one of the first and second push rods (46,56) it rotates about the pivot axis without causing movement of the contact element.

15. A wiring harness test system comprising a support surface including a predefined wiring route along which the wiring harness is mounted, the support surface including a plurality of test apparatus according to any preceding claim with a plurality of holders (30) arranged at locations along the wiring route corresponding to connector (1) locations, each holder having a unique identifier and being configured to confirm the presence of a connector (1) in the holder and to confirm that the connector (1) has at least one desired characteristic specific to the connector (1) required at that location, and a processor operative to receive a signal from each holder and to confirm based on said signals whether each holder contains a connector (1) and whether said connector (1) has the desired characteristic corresponding to that location.
